# EUROPEAN PATENT APPLICATION

(11) **EP 4 345 887 A1**
(43) Date of publication of application: **03.04.2024**
(21) Application number: 22198632.6
(22) Date of filing: 29.09.2022
(51) Int. Cl.: H01L 23/373, H01L 23/473

(54) **SYSTEM WITH ELECTRICAL COMPONENT**

(71) Applicant: MAHLE International GmbH, 70376 Stuttgart (DE)
(72) Inventor: HORVAT, Dr. Janko, 8430 Leibnitz (AT); PODRZAJ, Dr. Jurij, 1292 Ig (SI); SARJAS, Andreas, 9224 Turnisce (SI); SEVER, Dr. Peter, 9000 Murska Sobota (SI); TSCHEMERIS, Igor, 70806 Kornwestheim (DE)
(74) Representative: BRP Renaud & Partner mbB Rechtsanwälte Patentanwälte Steuerberater

(57) **Abstract**

The present invention relates to a system (1) which has at least one component package (2) each with at least one electronic component (3), in particular a semiconductor component (4). The respective component (3) has a first outer surface (6) and a second outer surface (7) facing away from the first outer surface (6).

Improved cooling efficiency and simplified manufacture are achieved by providing for at least one of the outer surfaces (6, 7) of the components (3) a cooler (11), wherein a flow path (12) in the cooler (11) substantially locally extends over the associated outer surface (6, 7).

The invention further relates to an electric application (100) comprising such a system (1).

## Description

The present invention relates to a system having at least two component packages comprising at least one electronic component, and having a cooler arrangement for cooling the at least one component. The invention further relates to an electric application comprising such a system.

Electronic components, in particular semiconductor components, are usually part of a system. Such electrical components usually generate heat during operation, which can impair the function of the electronic components and the system. For this reason, cooling is usually provided for the electronic components in such systems.

Such a system is known, for example, from DE 10 2019 202 452 A1. The system has at least two electronic components and a cooling module. The cooling module has a channel through which a flow path of a coolant leads. The components are arranged on the side of the cooling channel facing away from the flow path, wherein a cooling structure through which flow can pass is assigned to the respective component within the cooling channel.

Another such system is known from DE 10 2018 211 520 A1. The electronic components of the system are mounted on a printed circuit board. The system further comprises a cooling device with a channel structure through which a flow path of a cooling fluid leads. The circuit board is mounted on the side of the channel structure facing away from the flow path. The channel structure further comprises flow nozzles on the side facing away from the circuit board, which accelerate and direct the cooling fluid within the channel structure towards the components.

US 7,952,875 B2 shows a system with a busbar assembly of stacked busbars. The respective busbar has electronic components. In addition, the respective busbar has an integrated cooling system. The cooling system comprises heat sinks which also support the components.

The present invention is concerned with the problem of providing improved or at least other embodiments for a system of the type mentioned above, as well as for electric application with such a system, which in particular eliminate disadvantages from the prior art. In particular, the present invention is concerned with the problem of providing improved or at least other embodiments for the system and for the electric application which are characterized by improved cooling efficiency and simplified manufacture.

This problem is solved according to the invention by the objects of the independent claims. Advantageous embodiments are the object of the dependent claims.

Accordingly, the present invention is based on the general idea of providing a system with at least two electronic components and, the system, for at least one electronic component having at least one corresponding cooler wherein a cooling fluid flows through cooler and wherein in the cooler the flow path only locally extends over respective corresponding electronic component. Thus, each of the electronic components is locally cooled by the corresponding cooler. Consequently, waste of cooling capacity is at least reduced and cooling of the electronic components is improved while at the same time the manufacture and design of the system are simplified.

According to the idea of the invention, the system comprises a module with at least two component packages. The module is hereinafter also referred to as component module. Each of the component packages comprises at least one electronic component. Each electronic component has a first outer surface and a second outer surface facing away from the first outer surface. The component packages are distanced to one another in direction which rungs along the outer surfaces. This direction is hereinafter also referred to as package distance direction or distance direction for short. The component module has a plastic casing enclosing the component packages. The system further comprises a cooler arrangement. The cooler arrangement, for the respective component package, has at least one associated cooler wherein a flow path of a cooling fluid leads through each cooler. In at least one cooler the flow path extends substantially locally over the respective at least one first outer surface or substantially locally over the respective at least one second outer surface of the at least one electronic component of the component package associated to the cooler.

The respective outer surface of the components extends over an outer surface length and an outer surface width running transversely thereto. The two outer surfaces are spaced apart by the thickness of the component. Preferably the outer surface length or the outer surface width runs parallel to the package distance direction.

The flow path extending substantially locally over the associated outer surface in particular means that the flow path essentially only covers the associated outer surface length and/or outer surface width, in particular essentially only the area of the associated outer surface. "Essentially" means here that the flow path can extend slightly beyond the associated outer surface or covered area can be slightly smaller than the associated outer surface.

Preferably, the cooler arrangement comprises at least two cooler. Advantageously, in at least two of the coolers, preferably in each cooler, the flow path extends substantially locally over the respective at least one first outer surface or substantially locally over the respective at least one second outer surface of the at least one electronic component of the component package associated to the cooler.

The respective electronic component may be any electronic component. In particular, the respective electronic component is a semiconductor component and/or a power component.

The respective cooler conveniently has an inlet for admitting the cooling fluid and an outlet for discharging the cooling fluid.

Conveniently, each cooler delimits the flow path. In particular, each cooler is preferably designed such that, the cooling fluid can only flow through the cooler via the inlet and the outlet.

In the following, the respective electronic component is also referred to as component for short. Further, the component module is also referred to as module for short. In addition, the respective component package is also referred to as package for short.

In principle, the respective component can have any shape.

Preferably, the first outer surface and the second outer surface correspond to large outer sides of the component. That is, the thickness is smaller than the outer surface length and then the outer surface width. Thus, coolers are associated with the large outer surfaces of the component. This leads to a simplified and more efficient cooling of the components. In addition, the system is more compact along the thickness. Advantageously, the thickness is at most half as large as the outer surface length and as the outer surface width.

Advantageously, at least one of the components, advantageously the respective component, has a cuboid shape. Accordingly, the outer surfaces are identical. This leads to simplified manufacture of the system and improved cooling. In the case of a cuboid component, the outer surface length corresponds to the component length and the outer surface width corresponds to the component width. In addition, the thickness corresponds to the component thickness.

In principle, the cooling fluid can be any fluid.

In particular, the cooling fluid is a liquid, i.e. a cooling liquid. This allows increased heat transfer with the associated surface and thus with the respective component and consequently leads to improved cooling.

The cooling liquid may contain water and/or glycol. This leads to an improved heat transfer and thus to an improved cooling of the components.

It is convenient that the components are fluidically separated from the cooling fluid and in particular from the cooling liquid.

In principle, the cooler arrangement can have the at least one cooler for only one of the outer surfaces of the at least one component of the associated package.

The cooler arrangement may have a cooler dedicated to a single associated outer surface, wherein in the cooler the flow path extends substantially locally over the associated outer surface.

In case a component module and thus the at least two component packages have two or more electronic components, a common cooler can be used for at least two of the first outer surfaces, wherein in each cooler, the flow path only extends substantially locally over the respective first outer surface. In addition, or as an alternative, a common cooler can be used for at least two of the second outer surfaces, wherein in each cooler, the flow path only extends substantially locally over the respective second outer surface.

Thus, in advantageous embodiments, at least one of the component modules comprises at least two electronic components. The cooler arrangement for at least two of the at least two first outer surfaces of the at least two electronic components has a common first cooler, wherein in the first cooler the flow path only extends substantially locally over the respective first outer surface. In addition, or as an alternative, the cooler arrangement for at least two of the at least two second outer surfaces of the at least two electronic components have a common second cooler, wherein in the second cooler the flow path only extends substantially locally over the respective first outer surface. This leads to a simplified manufacture and assembly of the system.

Such use of a common cooler for at least two first or second outer surfaces requires an according delimitation of the flow path within the cooler. Such delimitation can be achieved by inner walls of the cooler.

Preferably a seal surrounds the coolers corresponding to each outer layer. The seal seals leakage of cooling fluid.

The sealing can be carried out in different ways depending on the material of the outer layer.

Sealing can be achieved with the use of a sealing element, e.g. an O-ring. In this case the cooler is designed in a way that the seal is delimiting the flow path on the outer layer itself. This means that the seal is in contact with outer layer and the cooler. The flow path is thus limited between the cooler and outer layer and is not in contact with plastic casing.

The sealing can alternatively or in addition be achieved by a hot melt seal. In this case, hot melt material can be applied to the outer layer and optionally to the plastic casing as well. The cooler is in direct contact with the hot melt and the cooling fluid and thus with the flow path. Thus the cooling fluid cannot flow across the interface between the hot melt and cooler. In this embodiment the flow path is delimited between the outer layer, the cooler and the hot melt material and is not in contact with plastic casing.

The seal can alternatively be achieved by soldering the cooler to the outer layer. With this approach the flow path is delimited between the cooler, the soldering material and outer layer.

In preferred embodiments, the module for at least one of the outer surfaces of at least one component comprises an associated outer layer on the outer side of the module, wherein at least one of the coolers is attached to the outer layer. The outer layer is different from the plastic casing. The outer layer is thus arranged on the side of the plastic casing facing away from at least one of the outer surfaces. The attachment of the cooler to the outer layer leads to a reduced thermal resistance and thus an improved cooling.

The outer layer can in principle be any outer layer different from the plastic casing.

The outer layer can be a hot melt.

Advantageously, the outer layer contains a metal or an alloy. This leads to an improved heat transfer between the cooler and the outer layer as well as between the layer and the outer surface of the component associated to the cooler.

Consequently, cooling of the component is improved and the efficiency is increased.

At least one of the outer layers, advantageously the respective outer layer, is preferably a layer of Direct Bonded Copper, hereinafter also referred to as DBC layer. The outer layer may contain Nickel for improved persistence against the cooling fluid, in particular against the cooling liquid. As an alternative or in addition a layer of a metal, for example a nickel plating, and/or a layer of an alloy may be interposed between at least one cooler and the associated outer layer. Alternatively, or additionally, a hot melt can be interposed between at least one cooler and the associated outer layer.

Preferably, at least one of the outer layers is directly attached to the associated plastic casing. This leads to a reduced thermal resistance and thus an improved cooling.

In the present context, "directly attached" means in particular attached in such a way that the parts attached to one another are in direct contact with one another or are attached to one another with the interposition of a connecting layer, such as an adhesive layer. The connecting layer can be arranged only locally between the parts.

"Directly attached" preferably means the absence of a thermal Interface Material, also known as "TIM" to those skilled in the art. That is, the direct attachment is free of TIM. TIM is usually used to fill a gap, in particular air gaps, between the corresponding parts. The direct attachment leads to the gap being filled without TIM and thus to a reduced overall thermal resistance. As a result, heat transfer and thus cooling is improved by omitting TIM. An adhesive layer is preferably applied locally between the parts to fix the parts relative each other. The adhesive layer might further remove or at least reduce said air gaps.

The respective outer layer advantageously does not perform a carrier function, i.e. it is not a support, in particular of the components. For this purpose, the outer layer is dimensioned accordingly, in particular in terms of thickness of the outer layer. In particular, the thickness of the outer layer is not greater than 1.5 mm. Thus, the path of heat transfer and the thermal resistance between the cooler, in particular the cooling fluid and the associated external surface is reduced. As a result, there is improved cooling of the component.

The respective DBC layer can consist of a ceramic layer between two layers of copper. As explained above, the three layers preferably have a total thickness of no more than 1.5 mm.

Preferably, the module for the first surfaces has a first outer layer arranged on the side of the first surfaces averted from the second surfaces, wherein the first coolers are attached to the first outer layer. This leads to a simplified manufacture of the system and an improved efficiency in cooling the components.

Preferably, the module for the second surfaces has a second outer layer arranged on the side of the second surfaces averted from the first surfaces, wherein the second coolers are attached to the second outer layer. This leads to a simplified manufacture of the system and an improved efficiency in cooling the components.

In preferred embodiments, the module for both outer surfaces of at least one components comprises an associated outer layer on the outer side of the module, wherein at least one of the coolers is attached to the outer layer. The result is an improved efficiency in cooling the components.

In particularly advantageous embodiments, the module for the first surfaces has a first outer layer arranged on the side of the first surfaces averted from the second surfaces, wherein the first coolers are attached to the first outer layer. In Addition, the module for the second surfaces has a second outer layer arranged on the side of the second surfaces averted from the first surfaces, wherein the second coolers are attached to the second outer layer. In this way, improved efficiency in cooling the components is achieved together with a simplified manufacture.

Each cooler may be attached to the associated outer layer in an arbitrary manner.

According to preferred embodiments at least one of the coolers, preferably each cooler, is directly attached to the associated outer layer. This leads to a reduced thermal resistance between the cooler and the associated components as well as to a reduction in waste of cooling capacity. Thus, efficiency in cooling is improved.

Advantageous embodiments are those in which at least one of the coolers and the associated outer layer, particularly the associated DBC layer, jointly delimit the flow path leading through the cooler, so that the outer layer is in contact with the cooling fluid during operation. The local extension of the cooler results in the cooling fluid to be in contact with the outer layer only locally over the associated outer surface. Thus, there is direct local heat transfer between the outer layer and the cooling fluid. This in turn leads to a locally selective heat transfer between the outer layer and the associated outer surface and thus to improved and selective heat transfer between the cooling fluid and the associated outer surface and consequently to improved efficiency in cooling the components.

In advantageous embodiments, at least one of the coolers, advantageously the respective cooler, has projections projecting into the flow path. The projections lead to an increase in the heat-transferring surface and consequently to improved cooling.

The projections are conveniently distanced to another. This leads to an increased total surface area of the projections and thus to improved heat transfer. The result is an improved efficiency in cooling the components.

The projections are advantageously arranged locally in the areas of the associated outer surface.

Each projection can be of an arbitrary shape. In particular, the respective projection can be designed in the manner of a pin.

In principle, the projections can project on the side facing away from the associated outer layer.

Advantageously, the projections project on the side facing the associated outer surface, preferably towards the associated outer surface, in particular towards the associated outer layer. Thus, heat transfer between the cooling fluid and the cooler is increased. The result is an improved efficiency in cooling the components.

At least a portion of the projections, preferably each projection, can be attached to the associated outer layer. This leads to a simplified manufacture of the system and an improved heat transfer and thus an improved efficiency in cooling the components.

At least a portion of the projections can be directly attached to the associated outer layer leading to an improved efficiency in cooling the components

A layer of TIM may be interposed between at least one of the projections and the associated outer layer. This leads to a simplified manufacture of the system.

If a cooler is assigned to each of the first outer surfaces and/or the second outer surfaces of the components, the coolers of the different modules are preferably spaced apart in the package distance direction.

In principle, each of the packaged can comprise a single component.

It is possible that at least one of the packaged comprises two or more components. In such a case, the components of the package can be spaced apart along the associated at least one cooler, such that the at least one associated cooler extends over the associated outer surface of the at least two components. Thus the at least two components are cooled with improved efficiency while manufacturing of the system is simplified.

In preferred embodiments, at least one of the component packages comprises at least two components, preferably merely two components, distanced to one another transverse to the package distance direction, more preferably transverse to the package distance direction and along the associated at least one cooler. This leads to an improved cooling efficiency as well as to a simplified manufacture and compact design of the system.

The cooling fluid can flow through each cooler in any manner. This means that the flow path can pass through the coolers in any way.

In particular, it is conceivable that the flow path leads parallel or successively through at least two of the at least two coolers. In particular, the flow path can lead parallel through the coolers or successively through the coolers.

For supplying the coolers with the cooling fluid, the system advantageously comprises an inlet duct arrangement having at least one inlet duct for supplying the cooling fluid to the coolers and an outlet duct arrangement having at least one outlet duct for discharging the cooling fluid from the coolers.

In the case of parallel flow of the cooling fluid through the coolers, i.e. if the flow path leads parallel through the coolers, the respective inlet of the coolers with parallel flow can be fluidically connected to the inlet channel arrangement and the respective outlet of the coolers with parallel flow can be fluidically connected to the outlet channel arrangement. It is conceivable to assign an inlet channel and an outlet channel to the respective first outer surface and an inlet channel and an outlet channel to the respective second outer surface.

If the cooling fluid flows through the coolers one after the other and thus in a successive manner, i.e. when the flow path leads through the coolers one after the other, the inlet of one of the coolers can be fluidically connected to the inlet duct and the outlet of the cooler to the inlet of the next cooler, wherein the outlet of the later cooler is fluidically connected to outlet duct.

Of course it is also possible that a part of the coolers is flown through parallel and another part of the coolers are successively flown through by the cooling fluid.

It is understood that the system can comprise two or more such component packages. In this case, the coolers dedicated to the respective component package can be fluidically connected, such that the cooling fluid flows through the cooler dedicated to the respective component package.

The system can be used in any application where electronic components are used and cooling of the components is desired, hereinafter also referred to as electric application.

In particular, it is conceivable to use the system in an inverter as an electric application. The inverter can be used in an electric machine.

Further, it is conceivable to use the system in an electric machine as an electric application. The electric machine might comprise the inverter.

The system, in particular the inverter, can be assigned to a stator of the electric machine, for example, in order to generate alternating current from a supplied direct current.

In principle, the electric machine can be of any design.

In particular, the electric machine can be an externally excited electric machine.

The electric machine is in particular a traction motor, which is used to drive a motor vehicle.

It is understood that, in addition to the system, such an electric application in particular the inverter and/or the electric machine, with the system is within the scope of the present invention.

Further important features and advantages of the invention are apparent from the dependent claims, from the drawings, and from the accompanying figure description based on the drawings.

It is understood that the above features and those to be explained below can be used not only in the combination indicated in each case, but also in other combinations or on their own, without departing from the scope of the present invention.

Preferred embodiments of the invention are shown in the drawings and will be explained in more detail in the following description, wherein identical reference signs refer to identical or similar or functionally identical components.

It shows, each schematically
- Fig. 1: a section through a system with a component module and a cooler arrangement,
- Fig. 2: an isometric, exploded view of the system,
- Fig. 3: an isometric, exploded view of coolers and associated electric component of the system,
- Fig. 4: an isometric view of a cooler of the cooler arrangement,
- Fig. 5: a top view of the cooler,
- Fig. 6: an isometric view of the system in a further exemplary embodiment,
- Fig. 7: a simplified representation of the system with flow paths,
- Fig. 8: a section through the system in the area of channels,
- Fig. 9: a section through the system in the area of the channels in another exemplary embodiment,
- Fig. 10: the view from Fig. 7 in a further exemplary embodiment,
- Fig. 11: a section through the system in a further exemplary embodiment,
- Fig. 12: a highly simplified view of an electric application with the system in a motor vehicle.

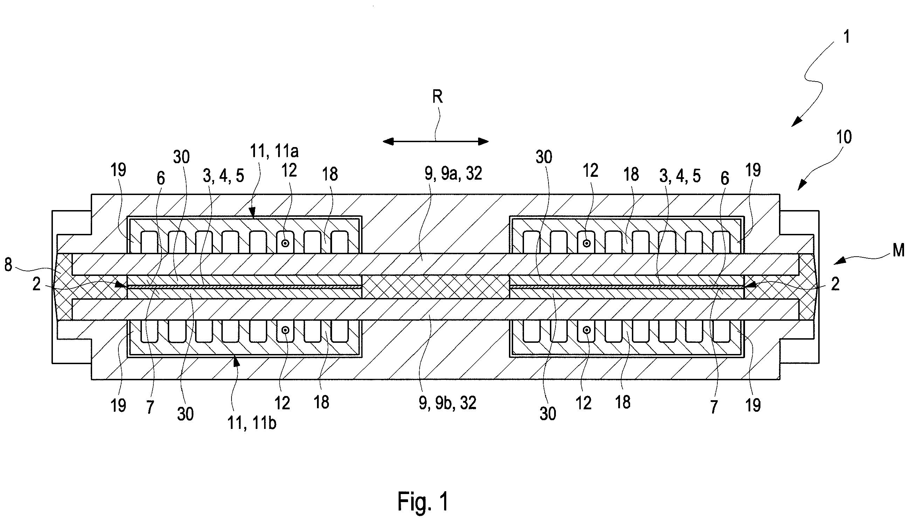

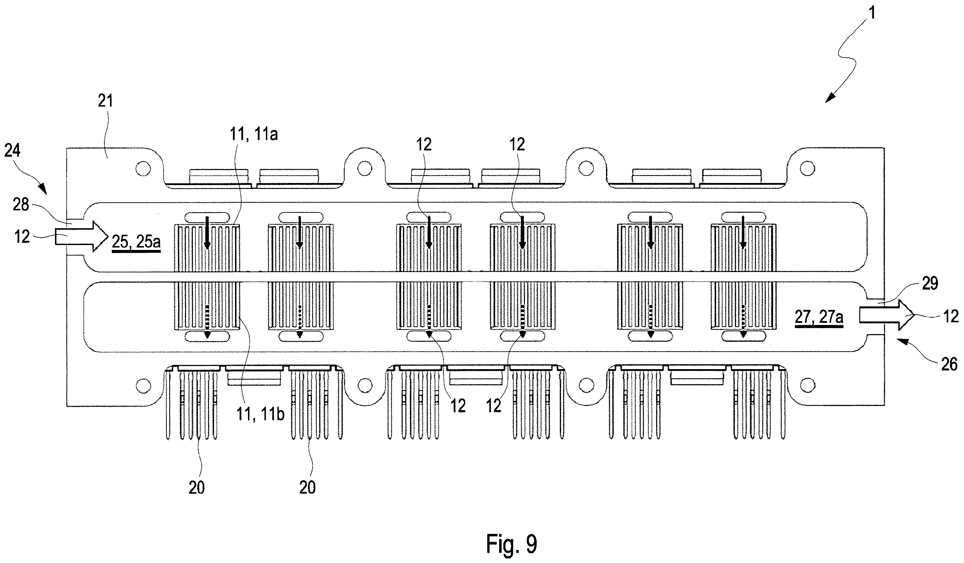

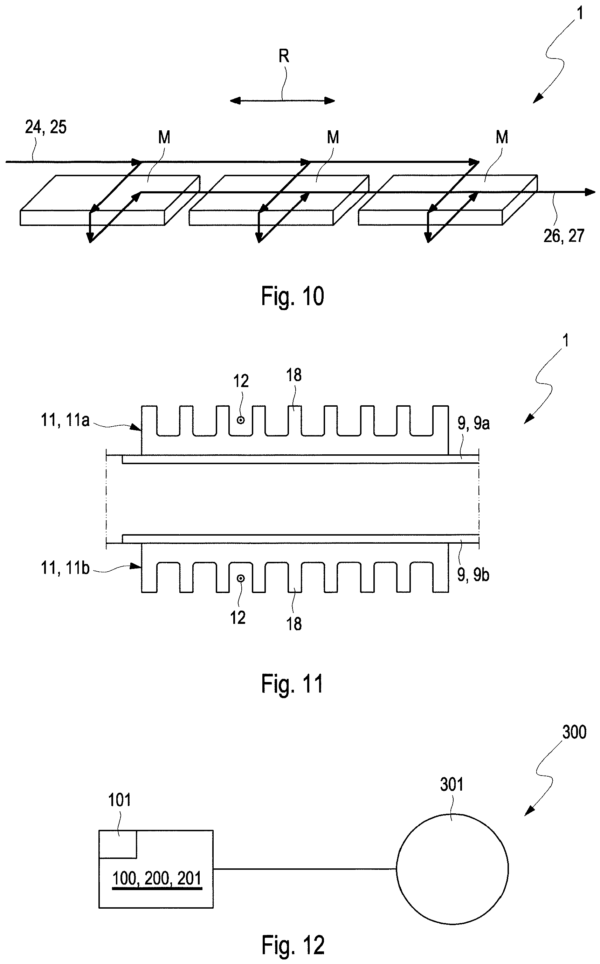

A system 1, as shown for example in Figures 1, 2, 3 and 6 to 12, comprises a component module M. the component module M comprises at least two component packages 2. In the exemplary embodiments shown the component module M comprises two component packages 2. Each component package 2 has at least one electronic component 3. In the exemplary embodiments shown each electronic component 3 is a semiconductor component 4, in particular an electrical power component 5. As shown for instance in Figure 12, the system 1 is used in an electric application 100, for instance in an inverter 101. In particular, the system 1 and/or the inverter 101 can be used in an electric machine 200. In the exemplary embodiment shown in Figure 12, the electric machine 200 is a traction motor 201, which in operation drives a motor vehicle 300. For this, as indicated in Figure 12, the traction motor 201 is drivingly connected to at least one wheel 301 of the motor vehicle 300.

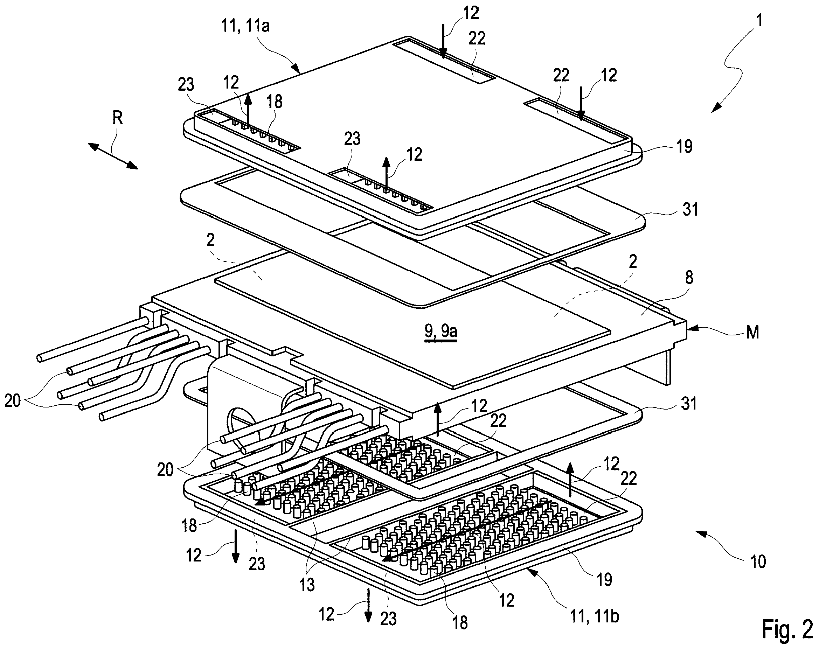

Each electronic component 3 has a first outer surface 6 and a second outer surface 7 facing away from the first outer surface 6. The component packages 2 are distanced to one another in a direction R which runs along the outer surfaces 6, 7. The direction R is also referred to as package distance direction R or distance direction R for short in the following. The component module M has a plastic casing 8 enclosing the component packages 2. Thus, the electronic components 3 are not visible in the isometric view of the component module M in Figure 2. The plastic casing 8 may be single part or multi-part. The system 1 further comprises a cooler arrangement 10. The cooler arrangement 10, for the respective component package 2, has at least one associated cooler 11. Further, as can be seen for example in Figure 2, a flow path 12 of a cooling fluid leads through each cooler 11.

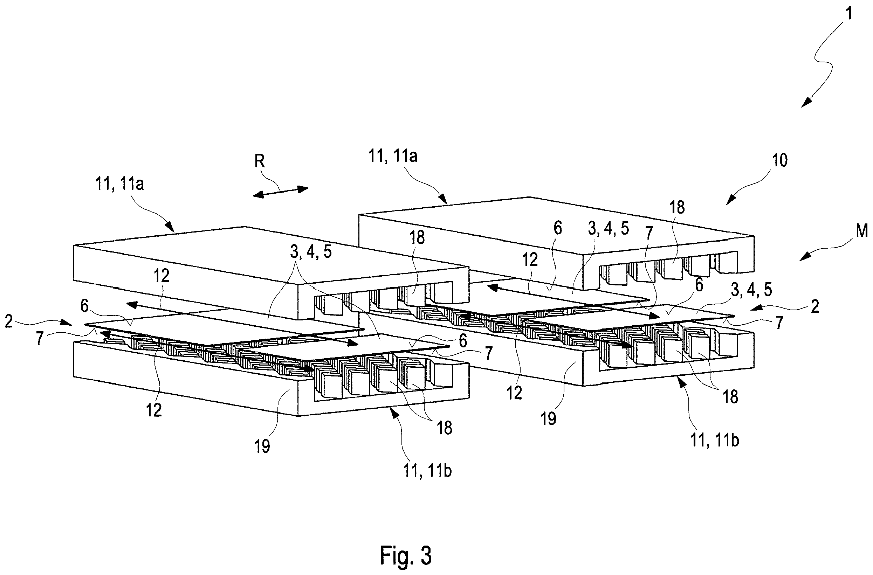

Figure 3 is an isometric, exploded view of the system 1 showing only the coolers and the electronic components 3.

As can be seen, in particular, from Figure 3, in at least one cooler 11, in the exemplary embodiments shown, in each cooler 11 the flow path 12 extends substantially locally over the respective at least one first outer surface 6 or substantially locally over the at least one second outer surface 7 of component package 2 of associated the cooler 11. That is, that the flow path 12 extends substantially locally over each outer surface 6, 7 and is substantially limited to the outer surface. In other words, the flow path 12 does not extend substantially extend beyond the respective outer surface 6, 7. As a result, the electronic components 3 are locally cooled by the cooler arrangement 11. Thus, waste of cooling capacity is at least reduced and cooling of the electronic components 3 is improved. This leads to an improved efficiency in cooling the electronic components. At the same time, the manufacture and design of the system 1 are kept simple.

In the exemplary embodiments shown the cooler arrangement 10, for each component 3 has an associated cooler 11. As can be seen, in particular in Figure 1 and Figure 3, in the exemplary embodiments shown, each outer surface 6, 7 of each electronic component 3 is cooled with the cooler arrangement 10, wherein in the coolers 11 the flow path 12 extends substantially locally over the respective outer surface 6, 7.

In the exemplary embodiments shown, each component modules M comprises at least two electronic components 3 (see Figures 1 and 3). The cooler arrangement 10 for at least two of the at least two first outer surfaces 6 of the electronic components 3 has a common first cooler 11, 11a, wherein in the first cooler 11, 11a the flow path 12 only extends substantially locally over the respective first outer surface 6. In addition, the cooler arrangement 10 for at least two of the at least two second outer surfaces 7 of the electronic components 3 has a common second cooler 11, 11b, wherein in the second cooler 11, 11b the flow path 12 only extends substantially locally over the respective second outer surface 7.

The cooling fluid is preferably a cooling liquid containing water and/or glycol. Each cooler 11 has an inlet 22 for admitting the cooling fluid and an outlet 23 for discharging the cooling fluid.

For the sake of simplicity, the respective electronic component 3 is also referred to as component 3 for short. Further, the component module M is also referred to as module M for short. In addition, the respective component package 2 is also referred to as package 2 for short. Moreover, the plastic casing 8 will also be referred to as casing 8 for short.

Conveniently, each cooler 11 is arranged on the side of the associated at least one outer surface 6, 7 averted from the other outer surface 6, 7. That is, coolers 11 associated to the at least one first outer surface 6 are arranged on the side of the associated at least one first surface 6 averted from the second outer surface 7, and vice versa.

In the exemplary embodiments shown and by way of example, each package 2 hat two components 3 distanced to one another transverse to the package distance direction R and along the outer surfaces 6, 7, as can be seen in Figure 3. Furthermore, in the exemplary embodiments shown and by way of example, one cooler 11 is associated to the first outer surfaces 6 of the components 3 of the associated package 2 and another cooler 11 is associated to the second outer surfaces 7 of the components 3 of the associated package 2. That is, the cooler arrangement 10 for the respective component package 2 has a first cooler 11, 11a associated to the first outer surfaces 6 of the components 3 of the associated component package 2. Each first cooler 11, 11a is arranged on the side of the plastic casing 8 facing away from the associated first outer surface 6. Furthermore, the cooler arrangement 10, for the respective component package 2 has a second cooler 11, 11b associated to the second outer surfaces 7 of the components 3 of the associated package 2. Each second cooler 11, 11b is arranged on the side of the plastic casing 8 facing away from the associated second surfaces 7. To achieve the flow path 12 to only extend substantially locally over the associated outer surfaces 6, 7, each cooler 11 can comprises at least two inner walls 13, as shown in Figure 2. Thus, in the exemplary embodiments shown, the module M comprises a total of four components 3. Further, the cooler arrangement 10, for each module M, comprises a total of two coolers 11. As can be seen in particular from Figure 2, the respective component 3 has electrical contacts 20 which are guided out of the casing 8 of the associated package 2.

As can be seen for example in Figure 1, in the exemplary embodiments shown, the module M comprises on the side of the casing 8 facing away from the outer surfaces 6, 7 an associated outer layer 9 different from the casing 8 is arranged and attached to the casing 8. In the exemplary embodiments shown and preferably the respective outer layer 9 is directly attached to the casing 8. The respective outer layer 9 is a DBC layer 32 in the exemplary embodiments shown. "DBC" is also known to those skilled in the art as "Direct Bonded Copper". The DBC layer 32 is therefore a layer 32 of "Direct Bonded Copper".

"Directly attached" in this context means either direct attachment, i.e. direct contact, or attachment with at least partial interposition of a connecting means, for instance an adhesive. In particular, "direct attachment" means that no TIM, i.e. "Thermal Interface Material", is provided between the parts attached directly to one another.

In the exemplary embodiments shown, an outer layer 9 is arranged on the side of the casing 8 facing away from the respective first outer surface 6 and an outer layer 9 is arranged on the side of the casing 8 facing away from the respective second outer surface 7. Thus, a first outer layer 9, 9a is attached on the side of the casing 8 facing away from the first outer surface 6 of the respective component 3, and a second outer layer 9, 9b is attached on the side of the casing 8 facing away from the second outer surface 7 of the respective component 3. As can be seen, for example from Figure 1, each outer layer 9 is arranged between the associated outer surfaces 6, 7 and the coolers 11 associated to these outer surfaces. That is, the first outer layer 9, 9a is arranged between the first outer surfaces 6 and the first coolers 11, 11a. Moreover, the second outer layer 9, 9b is arranged between the second outer surfaces 7 and the second coolers 11, 11b. Thus, the respective cooler 11 cools the associated outer surfaces 6, 7 via the corresponding outer layer 9. In the exemplary embodiments shown the first coolers 11, 11a are attached to the first outer layer 9, 9a and the second coolers 11, 11b are attached to the second outer layer 9, 9b. The attachment is direct in the shown examples and can be realized using an adhesive (not shown).

As can be seen, for example, in Figure 1, in the exemplary embodiments shown an additional layer 30 is arranged between the respective outer surface 6, 7 of the components 3 and the associated outer layer 9. The additional layer 30 may be a spacer and/or comprise soldering solder.

In the exemplary embodiments shown and as can be seen, for example, from Figures 1 and 2, the respective cooler 11 and the associated outer layer 9 jointly delimit the flow path 12 leading through the cooler 11, so that the outer layer 9 is in contact with the cooling fluid during operation. This means that the outer layer 9 is in contact with the cooling fluid during operation. This leads to improved heat transfer between the cooling fluid and the outer layer 9 and consequently to improved cooling of the respective component 3.

As can be seen, for example, in Figure 2, a seal 31 surrounds the coolers 11 corresponding to each outer layer 9. The seal 31 seals leakage of cooling fluid. The sealing can be carried out in different ways depending on the material of the outer layer 9. Sealing can be achieved with the use of an O-ring (not shown) and/or by a hot melt and/or by soldering the cooler 11 to the outer layer 9.

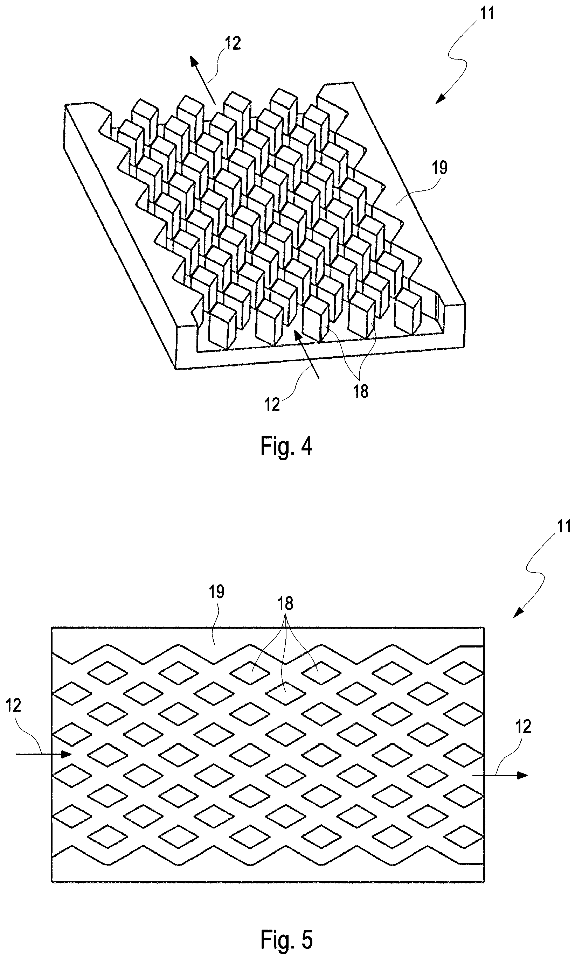

In the exemplary embodiments shown, the respective cooler 11 has projections 18 projecting into the flow path 12 (see Figure 1 to 5). By means of the projections 18, the heat-transferring surface of the cooler 11 is increased. As can be seen from Figures 4 and 5, the projections 18 in the exemplary embodiments shown are identically formed and regularly arranged in rows and columns. As can be seen in particular from Figures 4 and 5, in the exemplary embodiments shown, each cooler 11 has a cooler half-casing 19 from which the projections 18 project. The cooler 11 can be manufactured by injection molding, in particular by metal injection molding, by extrusion, and the like. In the exemplary embodiments shown, the projections 18 are attached, preferably directly attached, to the associated outer layer 9.

In the exemplary embodiment shown in Figure 10, the projections 18 project on the side of the cooler 11 facing away from the associated outer layer 9.

In the exemplary embodiment of Figures 1 to 3, the system 1 comprises one such module M with corresponding coolers 11.

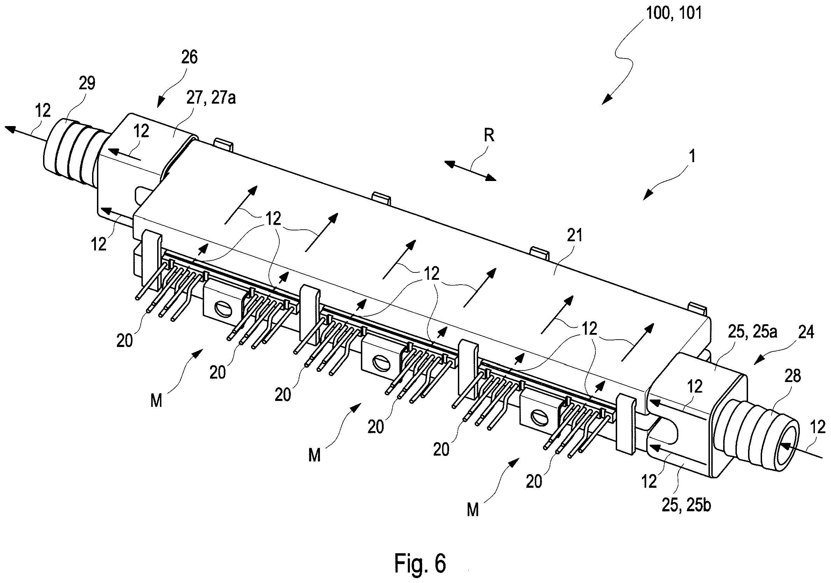

In the exemplary embodiments of Figures 6 to 10, the system 1 comprises at least two such modules M, each with corresponding such coolers 11 of the cooler arrangement 10. In these exemplary embodiments, the system 1 by way of example comprises three such modules M with corresponding coolers 11. Each module M and the corresponding coolers 11 are those shown in Figures 1 to 3.

According to Figure 6, the system 1 may have a housing 21 in which the at least one module M is accommodated. In the exemplary embodiment shown in Figure 6, the housing 21 has a double-casing design. In addition, the housing 21 has a housing inlet 28 for admitting the cooling fluid into the system 1 and a housing outlet 29 for discharging the cooling fluid from the system 1. The flow path 12 thus leads through the housing inlet 28 and the housing outlet 29.

The cooling fluid may flow through the coolers 11 in parallel, as shown in Figures 6 to 9, or in succession, as shown in Figure 10.

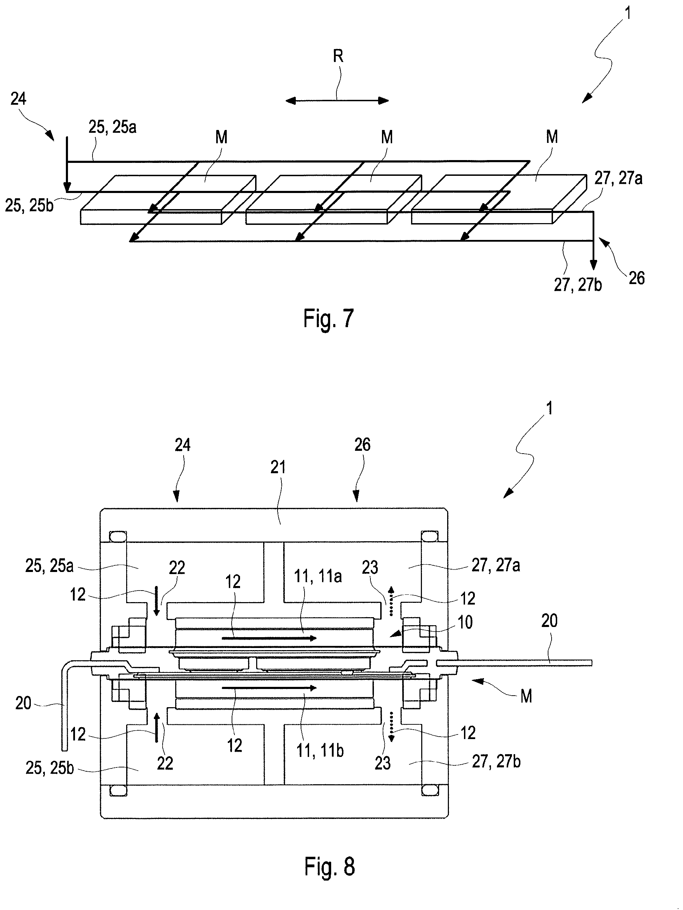

In the exemplary embodiments shown in Figures 6 to 9, the flow path 12 thus leads in parallel through the coolers 11. For this purpose, in the exemplary embodiments shown, the system 1 has an inlet duct arrangement 24 fluidically connected to the housing inlet 28, through which the cooling fluid flows in during operation. In the exemplary embodiments shown, the inlet duct arrangement 24 comprises two inlet ducts 25 adjacent transversely to the distance direction R, namely a first inlet duct 25, 25a and a second inlet duct 25, 25b. The inlet channels 25 run parallel in the exemplary embodiments shown. The respective inlet 22 of the first coolers 11, 11a is fluidically connected to the first inlet channel 25, 25a and the respective inlet 22 of the second coolers 11, 11b is fluidically connected to the second inlet channel 25, 25b, as particularly indicated in Figure 7. In addition, in the exemplary embodiments shown, the system 1 comprises an outlet channel arrangement 26 fluidically connected to the housing outlet 29, through which the cooling fluid flows out during operation. The outlet duct arrangement 26 has two outlet ducts 27, namely a first outlet duct 27, 27a and a second outlet duct 27, 27b. The outlet channels 27 are adjacent and parallel transversely to the distance direction R. The outlet 23 of the respective first cooler 11, 11a is fluidically connected to the first outlet channel 27, 27a and the outlet 23 of the respective second cooler 11, 11b is fluidically connected to the second outlet channel 27, 27b. As a result, a parallel flow through the cooler 11 occurs in the system 1, as indicated in Figures 5 to 8. The parallel flow is indicated in Figure 5 by the flow path 12, whereby the flow path 12 would not be visible in the view shown in Figure 5.

In the exemplary embodiment shown in Figure 10, the flow path 12 leads successively through the coolers 11. For this purpose, in the exemplary embodiment shown, the inlet channel arrangement 24 has an inlet channel 25, the inlet 22 of the first coolers 11, 11a being fluidically connected to the inlet channel 25. Furthermore, in the exemplary embodiment shown, the outlet channel arrangement 26 comprises an outlet channel 27, wherein the outlet 23 of the respective second cooler 11, 11b is fluidically connected to the outlet channel 27. Furthermore, in the exemplary embodiment shown, the outlet 23 of the respective first cooler 11, 11a is fluidically connected to the inlet 22 of the second cooler 11, 11b associated with the same component 3. In the shown exemplary embodiment, the inlet channel 25 and the outlet channel 27 are adjacent transversely to the distance direction R.

## Claims

1. System (1),
- having a component module (M) with at least two component packages (2), each component package (2) having at least one electronic component (3), in particular a semiconductor component (4), with a first outer surface (6) and a second outer surface (7) facing away from the first outer surface (6),
- wherein the component packages (2) are distanced to one another in a package distance direction (R) which runs along the outer surfaces (6, 7),
- the module (M) having a plastic casing (8) enclosing the component packages (2),
- with a cooler arrangement (10) which has, for the respective component package (2), at least one cooler (11), wherein each cooler (11) is associated to the at least one first outer surface (6) or at least one second outer surface (7) of the at least one electronic component (3) of the component package (2),
- wherein a flow path (12) of a cooling fluid leads through each cooler (11)
- wherein in at least one cooler (11) the flow path (12) extends substantially locally over the respective at least one first outer surface (6) or substantially locally over the respective at least one second outer surface (7) of the at least one electronic component (3) of the component package (2) associated to the cooler (11).

2. System according to claim 1,
**characterized in that**
in each cooler (11) the flow path (12) extends substantially locally over the respective at least one first outer surface (6) or substantially locally over the respective at least one second outer surface (7) of the at least one electronic component (3) of the component package (2) associated to the cooler (11).

3. System according to claim 1 or 2,
**characterized in that**
at least one of the component modules (M) comprises at least two electronic components (3),
- the cooler arrangement (10) for at least two of the at least two first outer surfaces (6) of the at least two electronic components (3) has a common first cooler (11, 11a), wherein in the first cooler (11, 11a) the flow path (12) only extends substantially locally over the respective first outer surface (6), and/or
- the cooler arrangement (10) for at least two of the at least two second outer surfaces (7) of the at least two electronic components (3) has a common second cooler (11, 11b), wherein in the second cooler (11, 11b) the flow path (12) only extends substantially locally over the respective second outer surface (7).

4. System according to and of claims 1 to 3,
**characterized in that**
- the component module (M) for at least one of the outer surfaces (6, 7) comprises an associated outer layer (9) on the outer side of the module (M),
- at least one of the coolers (11) is attached to the outer layer (9).

5. System according to claim 4,
**characterized in that**
- the module (M) for the first surfaces (6) has a first outer layer (9, 9a) arranged on the side of the first surfaces (6) averted from the second surfaces (7),
- the first coolers (11, 11a) are attached to the first outer layer (9, 9a).

6. System according to claim 4 or 5,
**characterized in that**
- the module (M) for the second surfaces (6) has a second outer layer (9, 9b) arranged on the side of the second surfaces (7) averted from the first surfaces (6),
- the second coolers (11, 11b) are attached to the second outer layer (9, 9b).

7. System according to any of claims 4 to 6,
**characterized in that**
at least one of outer layers (9) is a DBC layer (32).

8. System according to any of claims 4 to 7,
**characterized in that**
at least one of the coolers (11) is directly attached to the associated outer layer (9).

9. System according to any one of claims 4 to 8,
**characterized in that**
at least one of the coolers (11) and the associated outer layer (9) jointly delimit the flow path (12) leading through the cooler (11) so that the outer layer (9) is in contact with the cooling fluid during operation.

10. System according to any one of claims 1 to 9,
**characterized in that**
at least one of the coolers (11) has projections (18) projecting into the flow path (12).

11. System of claim 10 and any one of the claims 4 to 9,
**characterized in that**
at least a portion of the projections (18) are attached to the associated outer layer (9).

12. System according to any one of claims 1 to 11,
**characterized in that**
at least one of the component packages (2) comprises two components (3) distanced to one another transverse to the package distance direction (R).

13. System according to any one of claims 1 to 12,
**characterized in that**,
the system (1) has at least two such coolers (11), through each of which the flow path (12) leads, the system (1) being designed in such a way that the flow path (12) leads parallel through the coolers (11).

14. System according to claim 13,
**characterized in that**
- the system (1) has an inlet duct arrangement (24) through which the cooling fluid flows in during operation,
- the system (1) has an outlet duct arrangement (26) through which the cooling fluid flows out during operation,
- the respective inlet (22) is fluidically connected to the inlet channel arrangement (24) and the respective outlet (23) is fluidically connected to the outlet channel arrangement (26).

15. System according to any one of claims 1 to 14,
**characterized in that**
the system (1) comprises at least two such coolers (11) through each of which the flow path (12) passes, the system (1) being designed such that the flow path (12) passes through the coolers (11) in succession.

16. Electric application (100), in particular an inverter (101) or an electric machine (200), comprising a system (1) according to any one of claims 1 to 15.
